# EUROPÄISCHE PATENTANMELDUNG

(11) **EP 0 886 462 A2**
(43) Veröffentlichungstag der Anmeldung: **23.12.1998**
(21) Anmeldenummer: 98108142.5
(22) Anmeldetag: 05.05.1998
(51) Int. Cl.: H05K 5/00

(54) **Vorrichtung zur Aufnahme von elektrischen Bauteilen**

(30) Priorität: 14.05.1997 DE 19720106
(71) Anmelder: TEMIC TELEFUNKEN microelectronic GmbH, 74072 Heilbronn (DE)
(72) Erfinder: Babutzke, Wilfried, 73265 Dettingen (DE); Bunz, Oliver, 73230 Kirchheim (DE); Ohgke, Thomas, 73230 Kirchheim (DE)
(74) Vertreter: Maute, Hans-Jürgen, Dipl.-Ing.

(57) **Zusammenfassung**

Es sind verschiedene Vorrichtungen zur Positionierung und Ausrichtung von richtungsempfindlichen Bauelementen bekannt. Nachteilig bei diesen Vorrichtungen ist es, daß entweder zusätzliche mechanische Hilfsmittel benötigt werden oder immer nur ein Bauteil im Gehäuse ausgerichtet und positioniert wird. Bei der erfindungsgemäßen Vorrichtung wird eine bewegliche oder elastische Leiterplatte an einem Gehäuse befestigt, wobei das Gehäuse so geformt ist, daß richtungsempfindliche Bauelemente, Bau- oder Funktionsgruppen, die auf der Leiterplatte befestigt sind, positioniert und ausgerichtet werden. Mit dieser Vorrichtung lassen sich sehr einfach und kostengünstig auch mehrere richtungsabhängige Bauteile in einem Gehäuse positionieren.

## Beschreibung

**Die Erfindung betrifft** eine Vorrichtung zur Aufnahme von elektrischen Bauteilen gemäß dem Oberbegriff des Patentanspruchs 1.

In vielen Anwendungen ist die richtige und exakte räumliche Montage von Bauteilen in einem Gehäuse von großer Bedeutung. Die Funktionsweise und Eigenschaften derartiger Bauteile, die aus einem einzelnen Bauelement bestehen oder mit mehreren Bauelementen, Funktionsgruppen oder Baugruppen bilden, sind richtungsabhängig. Dies ist z.B. der Fall bei Beschleunigungssensoren, die ein Beschleunigungssignal in einer bestimmten Raumrichtung oder Ebene erfassen müssen. Derartige Beschleunigungssensoren müssen deshalb so ausgerichtet werden, daß sie das Beschleunigungssignal in der gewünschten Richtung erfassen. Auch bei anderen Bauteilen wie z.B. optoelektronischen Empfängern oder Sendern, die ein Signal aus einer definierten Richtung empfangen oder in eine bestimmter Richtung entsenden oder an einem bestimmten Ort etwas anzeigen sollen, ist die Lage im Gehäuse von großer Bedeutung. Befindet sich der hierfür benötigte Ort nicht direkt auf der Leiterplatte, die als Träger für die elektrischen und elektronischen Bauteile dient so werden zusätzliche mechanische und elektrische Vorrichtungen benötigt, die dann das richtungsabhängige Bauteil in der bevorzugten Ebene und/oder Richtung positionieren.

Es sind verschiedene Vorrichtungen bekannt die Bauteile genau positionieren und ausrichten. Eine Vorrichtung besteht aus einer Leiterplatte mit zusätzlichen mechanischen Trägern in Form von Abstandshaltern, Winkelelementen, usw. Durch diese Hilfsmittel werden die Bauteile auf der Leiterplatte positioniert und ausgerichtet. Ein anderes Verfahren positioniert das gesamte Gehäuse mit dem Träger in der gewünschten Position an einem Gerät, insbesondere einem Kraftfahrzeug.

**Nachteilig** an diesen Vorrichtungen ist jedoch, daß sie einerseits sehr aufwendig sind und andererseits eine Positionierung in nur einer Richtung zulassen. Auch werden bei den bisher geläufigen Vorrichtungen zusätzliche Träger benötigt. Weiter können mit diesen Vorrichtungen die Bauteile im gleichen Gehäuse nur auf einer Ebene ausgerichtet werden. Weiter sind bewegliche bzw. elastische Trägermaterialien insbesondere Leiterplatten bekannt. Diese flexiblen Leiterplatten werden immer dann verwendet, wenn ein platzsparender Aufbau benötigt wird oder sich die elastische Leiterplatte an Gehäusegegebenheiten anpassen muß.

**Der Erfindung liegt daher die Aufgabe zugrunde** eine Vorrichtung der eingangs genannten Art aufzuzeigen, die eine einfache und vielfältige Positionierung von Bauteilen zuläßt und ohne zusätzliche Hilfsmittel auskommt.

**Diese Aufgabe wird erfindungsgemäß durch das Merkmal im Patentanspruch 1 gelöst.** Hierbei wird das Bauteil auf einen zumindest teilweise beweglichen und/oder flexiblen Träger angebracht, der gleichzeitig als Leiterplatte dient. Dieser Träger wird dann direkt an eine Montagefläche des Gehäuses angebracht, wobei die Montagefläche so geformt ist, daß das richtungsabhängige Bauteil daran positioniert und ausgerichtet wird und der Träger dadurch in mehrere Ebenen ragt.

**Die mit der Erfindung erzielten Vorteile** bestehen darin, daß das Bauteil durch den am Gehäuse angeschmiegten Träger immer in die exakte Position gebracht wird. Der Aufwand hierfür ist sehr gering und bedarf nur einer zumindest teilweise beweglichen Leiterplatte und ein den Anforderungen angepaßtes Gehäuse. Da in der Regel die Gehäuseteile durch einen Vergießprozeß hergestellt werden, spielt es keine Rolle welche Form die Wandung oder eine andere Montagefläche hat. Auch können mit identischen Trägern, die in verschieden ausgeformte Gehäuse montiert werden, z.B. unterschiedliche Beschleunigungssensoren aufgebaut werden.

**Weitere vorteilhafte Weiterbildungen** ergeben sich aus den Unteransprüchen. Hier wird das Verfahren mit verschiedenen Materialien aufgezeigt, die eine besonders einfache Ausführungsform erlauben. Weiterhin können in dieser Vorrichtung mehrere richtungsabhängige Bauteile in einem Gehäuse in einem Arbeitsgang in die richtige Position gebracht werden.

Im folgenden soll die Erfindung anhand von **Ausführungsbeispielen** in Zusammenhang mit den Zeichnungen dargestellt werden.
- **Figur 1a:**: Elastischer Träger
- **Figur 1b:**: Starrer Träger mit beweglichen Vorrichtungen
- **Figur 2:**: Gehäuse mit Träger

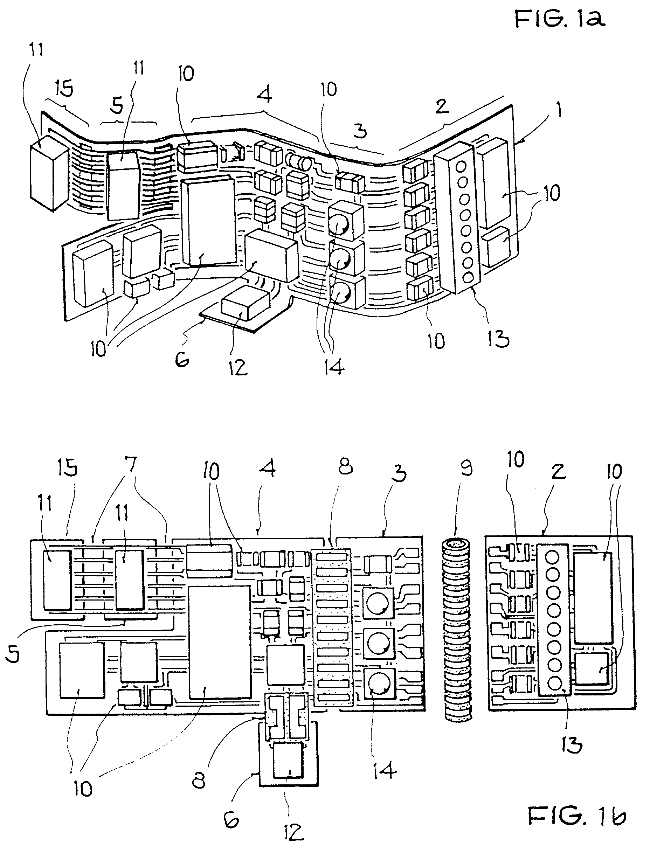

**Figur 1a** zeigt einen Träger **1** der für das einfache Verfahren zur räumlichen Positionierung bzw. Ausrichtung verwendet werden kann. Der abgebildete Träger **1** hat nicht nur die Aufgabe, daß Bauelemente **10**, **11**, **12**, **13**, **14** an ihm befestigt werden, sondern er stellt auch die elektrische Verbindung zwischen den einzelnen Bauelementen dar. Im einfachsten Fall kann der Träger als Leiterplatte beschrieben werden. In diesem Anwendungsbeispiel besteht er aus einem elastischen Material. Hierbei können verschiedene biegsame Materialien verwendet werden, wie z.B. dünnes biegsames Polyimid oder FR4, das sich an das Gehäuse oder die Montageflächen anpaßt bzw. anschmiegt ohne daß die Zuleitungen zerstört werden und sich die darauf montierten Bauelemente ablösen. Dieser Träger weist zum einen richtungsabhängige Bauelemente **11**, **12**, **13**, **14** und zum anderen aktive oder passive richtungsunabhängige Komponenten **10** auf. Diese Bauteile sind auf den verschiedenen Trägerteilstücken **2**, **3**, **4**, **5**, **6** und **15** montiert.

**Figur 1b** zeigt eine starre Leiterplatte **1** die scharnierartigen Vorrichtungen **7**, **8**, **9** aufweist. Das starre bzw. feste Material, wie z.B. starres FR4, kann durch die scharnierartige Vorrichtungen **7**, **8**, **9** biegsam gemacht werden. Dabei können sowohl sogenannte "flying leads" **7** die elektrische und flexible Verbindung zwischen den einzelnen Teilbereichen herstellen. Eine andere Möglichkeit zur Erzielung der Beweglichkeit besteht in der Verwendung von sogenannten Starr-Flex-Starr Verbindungen. Hierbei kann es sich um Verbindungen handeln, bei denen zwei starre Träger z.B. durch eine flexible Folie **8** verbunden sind oder durch ein flexibles Flachbandkabel. Eine andere scharnierartige Vorrichtung die die einzelnen Leiterplattenteilbereiche **2**, **3**, **4**, **5**, **6**, **15** miteinander mechanisch und elektrisch verbindet, besteht aus einer zylinderförmigen Vorrichtung **9** die rundherum Leiterbahnen aufweist, so daß die Leiterplatten bei einer Bewegung um den Zylinder elektrisch in Verbindung bleiben. Derartige Leiterplatten **1** können im ebenen Zustand, also wenn alle Teilbereiche **2**, **3**, **4**, **5**, **6**, **15** sich in der gleichen Ebene befinden sehr einfach und exakt mit den Bauteilen **10**, **11**, **12**, **13** ,**14** vollautomatisch bestückt werden. Dadurch ist ein kostengünstiger Aufbau gewährleistet. Dieser Träger weist auch aktive oder passive richtungsunabhängige Komponenten **10** auf. Diese Bauteile sind gleichfalls auf dem Träger montiert und elektrisch miteinander verbunden.

Die Bestückung mit den Bauteilen **10**, **11**, **12**, **13** und **14** der in Figur 1a und 1b beschriebenen Träger erfolgt vollautomatisch in einer Ebene.

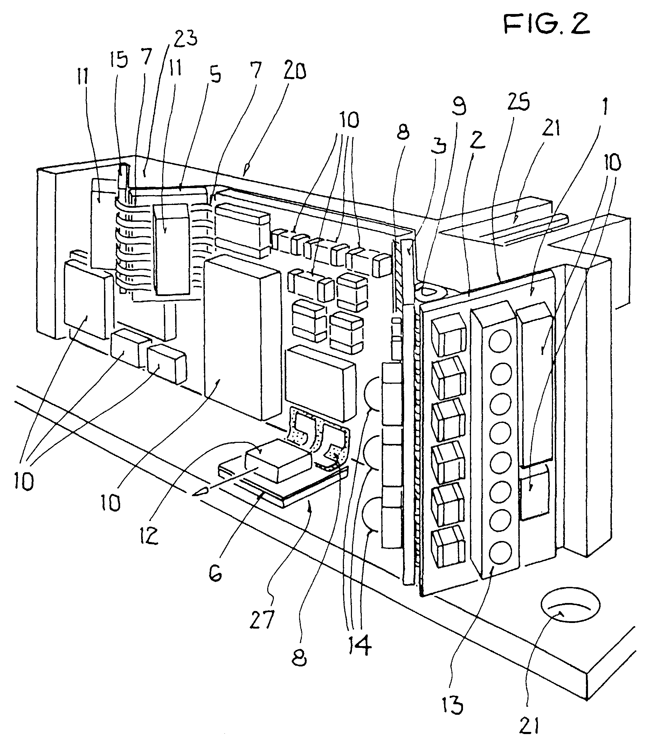

**Figur 2** zeigt ein Anwendungsbeispiel, das nach dem erfindungsgemäßen Verfahren aufgebaut wird. Hier wurde der in Figur 1b beschrieben Träger **1** in einem Gehäuse **20** angebracht. Durch die spezielle Form des Gehäuses **20** an den Stellen **23**, **24**, **25**, **27**, **28** wurden dadurch automatisch die richtungsabhängigen Bauteile **11**, **12**, **13**, **14** positioniert und ausgerichtet. Der Träger in diesem Anwendungsbeispiel die Leiterplatte **1** wird in das Gehäuse **20** eingelegt. Beim Einlegen bzw. bei der Montage mittels spezieller Werkzeuge, die eine exakte Positionierung ermöglichen, schmiegt sich die Leiterplatte an die Wände bzw. Montageflächen **23**, **24**, **25**, **26**, **27**, **28** des Gehäuses **20**. In diesem Anwendungsbeispiel weisen die Wände **23**, **24**, **25**, **28** Schrägen auf. Die Schrägen **23**, **24**, **25**, **28**, die Leiterplatte **1** und die Position des richtungsabhängigen Bauteils **11**, **12**, **13**, **14** auf der Leiterplatte sind vorab so berechnet bzw. konstruiert worden, daß wenn die Leiterplatte an dieser Wand montiert wird, das Bauteil positioniert und ausgerichtet ist. Weiterhin muß die Lage der scharnierartigen Vorrichtungen **7**, **8**, **9** auf der festen Leiterplatte **1** oder einer elastischen Leiterplatte, in der Gesamtkonstruktion berücksichtigt werden. Diese Vorrichtungen **7**, **8**, **9** die die Leiterplatte **1** beweglich machen ermöglichen erst eine Anschmiegung der eigentlichen starren Leiterplatte **1** an das Gehäuse **20**. Nicht abgebildet ist die Variante bei der der Träger bzw. die Leiterplatte aus einem, wie in Figur 1a beschriebenen, flexiblen Material, besteht, das beim Verbiegen alle Funktionen beibehält, das heißt z.B. Leiterbahnen werden nicht zerstört, Bauteile springen nicht ab. Bei der Montage der Leiterplatte **1** in das Gehäuse **20** werden diese bleibend miteinander verbunden, so daß ein Verrutschen nicht mehr möglich ist.

Als Befestigungsmöglichkeiten können Befestigungsmittel wie z.B. Clipse und Schrauben gewählt werden. Auch kann die Leiterplatte eingeklebt, eingelötet oder eingeklemmt werden.

In dem hier abgebildeten Ausführungsbeispiel besteht die Leiterplatte aus mehreren flexibel miteinander verbundenen Teilbereichen **2**, **3**, **4**, **5**, **15** und **6**. Diese Teilbereiche sind so geformt, daß bei der Anbringung der Leiterplatte ein richtungsabhängiges Bauteil richtig positioniert wird. Wird auf die Gehäuseschräge **23** der Leiterplattenteilbereich **5** befestigt, so wird z.B. der piezoresistive Beschleunigungssensor **11** in der gewünschten Richtung x automatisch richtig positioniert. Dies gilt auch für den anderen Beschleunigungssensor **11** auf dem Leiterplattenteilstück **15**, der auf der anderen Gehäuseschräge **28** befestigt ist. Die Beschleunigungssensoren sind über Leiterbahnen mit der restlichen Leiterplatte verbunden. Die flexible, bewegliche Vorrichtung **7** gestattet es das Teilstück **5** gegenüber dem Teilstück **4** zu bewegen, so daß sich die Flächen nicht mehr in ein und derselben Ebene befinden. Das Leiterplattenteilstück **4** mit den darauf befindlichen Bauteilen wird eben an der Gehäusewand **26** befestigt. Das Leiterplattenteilstück **6** wird aus der Ebene des Leiterplattenteilstückes **4** bewegt und dann am Gehäuseboden **27** angebracht. Dadurch wird der Laser, der sich auf diesem Teilstück befindet positioniert und ausgerichtet. Daraufhin wird das Leiterplattenteilstück **3** über eine flexible Folie, die die zwei Teilbereiche elektrisch miteinander verbindet, in eine andere Ebene gedreht so daß es auf der Gehäuseschräge **24** angebracht wird. Dabei wird ein Empfänger **14** in y-Richtung ausgerichtet. Zuletzt wir das Teilstück **2** über die flying leads aus der bisherigen Ebene gedreht und an der anschließenden Gehäuseschräge **25** ausgerichtet wodurch eine LED-Zeile **13** positioniert wird, um z.B. an einer Abdeckung als Statusanzeige zu dienen. Bei diesem Anwendungsbeispiel wird die Leiterplatte mit dem Stecker **21** kontaktiert. Die Kontaktierstellen sind in der Figur nicht ersichtlich. Abschließend wird nach dem Verschließen das so bestückte Gehäuse über die Montagelöchen **22** z.B. am Kraftfahrzeug oder an einer anderen Vorrichtung angebracht.

Die Figur 2 soll zeigen, daß das Gehäuse nicht nur zum Schutz der Bauteile benötigt wird sondern gleichzeitig bei Verwendung der bereits beschriebenen beweglichen oder flexiblen Leiterplatte zur Positionierung und Ausrichtung von Bauteilen oder Funktionsgruppen dient. Hierbei spielt es keine Rolle ob das richtungsabhängige Bauteil nur auf eine Raumrichtung, wie z.B. im Falle der Beschleunigungssensoren oder auf einen Punkt, wie z.B. im Falle des Laser ausgerichtet werden muß.

In einem weiteren Anwendungsfall, welcher nicht abgebildet ist, kann auf der bewegliche Leiterplatte bzw. der elastischen Folie ein piezoresistiver Beschleunigungssensor angebracht sein. Dies dient der Messung von Beschleunigungen zur Auslösung von Sicherheitsvorrichtungen. Desweiteren sind auf diesem Träger weitere aktive und passive Bauelemente angebracht, die zur Signalverarbeitung des Beschleunigungssignals dienen. Dieser Träger wird, wie in Figur 2 beschrieben, in ein Gehäuse eingebracht und bildet einen Beschleunigungsmesser. Die Schaltung und die Bauteile zur Messung und Auswertung des Beschleunigungssignals auf dem Träger sind immer gleich unabhängig in welcher Raumebene die Beschleunigung gemessen werden soll und unabhängig vom Kraftfahrzeug, der je nach Typ unterschiedliche Montageorte für die Beschleunigungsmesser vorschreibt. Die Ausrichtung des Beschleunigungssensors im Gehäuse ist abhängig von der Hauptempfindlichkeitsachse und von der Anbringung des Gehäuses am Kraftfahrzeug. Mit der unter Figur 2 beschriebenen Vorrichtung ist es möglich, mit ein und derselben beweglichen bestückten Leiterplatte oder flexiblen Folie verschiedene Anwendungen abzudecken. Die Anpassung an die jeweils benötigte Hauptempfindlichkeitsachse, an die Anbringung am Kraftfahrzeug und/oder an den Kraftfahrzeugtyp erfolgt allein durch die Gehäuseform oder eine andere Montagefläche, auf die der Träger insbesondere die Leiterplatte oder die elastische Folie angebracht wird. Es können verschiedene Beschleunigungsmesser mit ein und demselben Träger aufgebaut werden. Durch das beschriebene Verfahren lassen sich unterschiedliche Beschleunigungsmesser für unterschiedliche Anwendungen bzw. Hauptempfindlichkeitsachsen einfach und kostengünstig aufbauen.

Desweiteren dient der Träger bei allen Anwendungen sowohl zur elektrischen als auch zur mechanischen Verbindung der Bauteile und erfüllt somit gleich mehrere Anforderungen.

## Patentansprüche

1. Vorrichtung zur Aufnahme von elektrischen Bauteilen (11, 12, 13, 14) bei der bezüglich der Einbaulage des Gehäuses wenigstens ein Bauteil in einer bevorzugten Ebene und/oder Richtung positioniert ist, **dadurch gekennzeichnet, daß**
- wenigstens ein Bauteil (11, 12, 13, 14) auf einen zumindest teilweise beweglichen oder flexiblen Träger (1) angebracht ist,
- der Träger (1) in dem Gehäuse eine räumliche Anordnung aufweist und
- zumindest Teile einer Montagefläche (23, 24, 25, 27, 28) so geformt sind, daß beim Anbringen des beweglichen oder flexiblen Trägers (1) an der Montagefläche (23, 24, 25, 27, 28) das Bauteil (11, 12, 13, 14) in der bevorzugten Ebene oder Richtung positioniert und ausgerichtet ist.

2. Vorrichtung nach Patentanspruch 1, **dadurch gekennzeichnet, daß** das Baute sowohl als ein einzelnes Bauelement, insbesondere ein Beschleunigungssensor (11), oder eine Funktionsgruppe oder eine Baugruppe auf den Träger (1) montiert wird.

3. Vorrichtung nach Patentanspruch 1, **dadurch gekennzeichnet, daß** der zumindest teilweise bewegliche oder flexible Träger (1) aus:
- dünnem, biegsamen Polymer oder einem anderen biegsamen Material oder
- einem starren Material mit flying leads oder
- einer Starr-Flex-Starrverbindung, bei welcher ein starrer Trägerteil durch eine flexible oder scharnierartige Verbindung mit einem anderen starren Trägerteil verbunden ist,
aufgebaut ist.

4. Vorrichtung nach Patentanspruch 1, **dadurch gekennzeichnet, daß** mehrere richtungsabhängige Bauteile (11, 12, 13, 14), die sich auf ein und demselben Träger (1) befinden, in verschiedenen Ebenen, positioniert und ausgerichtet werden.

5. Vorrichtung nach Patentanspruch 1, **dadurch gekennzeichnet, daß** diese Vorrichtung ein Beschleunigungsmesser ist, der in einer bestimmten Einbaulage am Kraftfahrzeug montiert ist und eine kinetische Größe in einer bevorzugten Ebene erfaßt.
